# EUROPEAN PATENT APPLICATION

(11) **EP 1 564 593 A2**
(43) Date of publication of application: **17.08.2005**
(21) Application number: 05002777.0
(22) Date of filing: 10.02.2005
(51) Int. Cl.: G03F 7/20

(54) **Exposure apparatus and exposure method**

(30) Priority: 12.02.2004 JP 2004034462
(71) Applicant: CANON KABUSHIKI KAISHA, Tokyo (JP)
(72) Inventor: Kohno, Michio, Tokyo (JP)
(74) Representative: TBK-Patent

(57) **Abstract**

An exposure apparatus (1) includes a projection optical system (30) for projecting a pattern of a reticle (20) onto an object (40) to be exposed, by utilizing exposure light, an optical element (140) for determining a shape of an effective light source, a drive unit (300) for driving the optical element (140), a measuring unit (200) for measuring the shape of the effective light source or a corresponding shape of the exposure light, and a controller (400) for controlling driving of the optical element (140) by the drive unit (300) and for adjusting the shape of the effective light source based on a measurement result by the measuring unit (200).

## Description

The present invention relates generally to exposure, and more particularly to an exposure apparatus and method used to expose an object, such as a single crystal substrate for a semiconductor wafer and a glass plate for a liquid crystal display ("LCD"). The inventive exposure apparatus and method are suitable, for example, for control over a shape of an effective light source. The "effective light source", as used herein, means a light intensity distribution on a pupil surface in a projection optical system in an exposure apparatus, and an angular distribution of the exposure light incident upon an image surface of the projection optical system, such as a surface on which a wafer's photosensitive layer is arranged.

A conventionally employed reduction projection exposure apparatus uses a projection optical system to project a circuit pattern of a mask (or a reticle) onto a wafer, etc. and to transfer the circuit pattern, in manufacturing such a fine semiconductor device as a semiconductor memory and a logic circuit in photolithography technology. The minimum critical dimension ("CD") transferable by the projection exposure apparatus or resolution is proportionate to a wavelength of light used for the exposure, and inversely proportionate to the numerical aperture ("NA") of the projection optical system. A recent demand for finer processing to semiconductor devices promotes uses of the exposure light having a shorter wavelength and the projection optical system having a higher NA, but the short wavelength and high NA are not enough for this demand.

Accordingly, the resolution enhanced technology ("RET") has been recently proposed which reduces a process constant k₁ (k₁ = (resolvable CD) x (projection optical system's NA) / (exposure light's wavelength)) for finer processing. The RET includes an optimization of a reticle that provides a reticle pattern with an auxiliary pattern and a CD offset according to the characteristic of the exposure optical system, and a modified illumination (which is also referred to as an oblique incidence illumination, a multi-pole illumination, or an off-axis illumination). While the current modified illumination generally uses annular, dipole and quadrupole illuminations, it is expected that a sex-pole and an octpole will be proposed in the near future as the fine processing becomes ultimate.

In the meantime, the recent semiconductor industry has shifted its production to a highly value-added system chip that has various types of patterns that are not limited to an adjacent and periodic line and space ("L&S") pattern, an adjacent and periodic contact hole row (which arranges holes at the same interval as the hole diameter), a non-adjacent and isolated contact hole, and another isolated pattern, and it is necessary to select an optimal effective light source according to pattern types. For example, it is necessary to arrange a pole in the modified illumination at an arbitrary position on the pupil surface in the projection optical system.

The conventional exposure apparatus arranges a refractive optical element, such as concave and convex prisms at a light source side of an integrator, changes an annular ratio of the effective light source by displacing the optical element, and enlarges or reduces a projected image on an integrator (or a surface conjugate with the pupil in the projection optical system) via a zooming condenser lens. See, for example, Japanese Patent Applications, Publication Nos. 2000-58441 (corresponding to U.S. Patent No. 6,452,662 B2), 2003-318087 (corresponding to U.S. Patent Application, Publication No. 2003019838A1), and 2003-318086 (corresponding to U.S. Patent Application, Publication No. 20030197847A1).

Also proposed is a method for creating an arbitrary effective light source using a computer generated hologram ("CGH") that is one type of a diffraction optical element. The CGH is an optical element that has a stepwise phase characteristic on a glass plate through a processing method, such as optical etching. The light irradiated from a light source is diffracted on the CGH, and forms a Fourier transformation image on a focal plane of a condenser lens. In general, the focal plane approximately accords with and an integrator's incident surface, and thus the Fourier transformation image is projected onto the pupil surface in the projection optical system as it is. Therefore, an arbitrary effective light source can be formed when the CGH is designed to form an arbitrary Fourier transformation image.

The above prior art cannot control a shape of an effective light source optimal to various (reticle) patterns with precision, or obtain a high resolution. For example, the diffraction optical element, such as a CGH, is designed through digital calculations using a computer for a desired Fourier transformation distribution. However, settings of a calculation area to be transacted and a minimum unit to be handled generate calculation errors or so-called digital errors, and have a problem in that an actual product differs from a desired Fourier transformation distribution (or the shape of the effective light source).

In addition, the optical etching for producing the CGH also causes a problem in that an actual product differs from a desired Fourier transformation distribution (or a desired shape of the effective light source), because an actual product differs from a designed etching step height due to the processing condition and an alignment error occurs at the time of stacking second and third layers.

The exposure apparatus includes an optical element, such as an integrator, for stabilizing the light and for mitigating the influence to the subsequent illumination light even when the light from the laser etc. fluctuates due to external vibrations. Therefore, the light enters a substantially certain area on the CGH, but the angular distribution of the light incident upon the CGH does not necessarily become uniform. As a result, the diffracted light exited from the CGH swells by the angular distribution of the incident light. Strictly speaking, the exit light distribution from the CGH is given by a superimposition between a distribution of the diffracted light exited from the CGH when the parallel light enters the CGH and an angular distribution of the light incident upon the CGH. Furthermore, the aberrational characteristic of the condenser lens (or a Fourier transformation lens) deforms or blurs the Fourier transformation distribution.

An exposure apparatus according to one aspect of the present invention includes a projection optical system for projecting a pattern of a reticle onto an object to be exposed, by utilizing exposure light, an optical element for determining a shape of an effective light source, a drive unit for driving the optical element, a measuring unit for measuring the shape of the effective light source or a corresponding shape of the exposure light, and a controller for controlling driving of the optical element by the drive unit and for adjusting the shape of the effective light source based on a measurement result by the measuring unit.

An exposure apparatus according to another aspect of the present invention includes a projection optical system for projecting a pattern of a reticle onto an object to be exposed, by utilizing exposure light, a reticle stage for holding the reticle, and a detector, arranged between the reticle stage and the projection optical system, for detecting a shape of the exposure light.

An exposure apparatus according to another aspect of the present invention includes a projection optical system for projecting a pattern of a reticle onto an object to be exposed, by utilizing exposure light, and an optical element for determining a shape of an effective light source, wherein the optical element includes a diffraction optical element for transforming a shape of the exposure light into a predetermined shape, and a light deflector for transforming the shape of the exposure light from the diffraction optical element into a rotationally symmetrical shape, and wherein the predetermined shape has a first illumination area apart from an optical axis by a first distance, and a second illumination area apart from the optical axis by a second distance different from the first distance.

An exposure apparatus according to another aspect of the present invention includes a projection optical system for projecting a pattern of a reticle onto an object to be exposed, by utilizing exposure light, an optical element for determining a shape of an effective light source, a drive unit for driving the optical element, a measuring unit for measuring the shape of the effective light source or a corresponding shape of the exposure light, and a controller that calculates image performance of the pattern to be transferred to the object based on a measurement result by the measuring unit, and controls driving of an optical element for determining the shape of the effective light source based on the calculated image performance.

An exposure method according to still another aspect of the present invention for transferring a pattern of a reticle onto an object to be exposed, via a projection optical system using exposure light, includes the steps of obtaining information of a shape of an effective light source, calculating image performance of the pattern to be transferred onto the object based on the information, and driving, based on the image performance that has been calculated, an optical element for determining the shape of the effective light source.

A device manufacturing method according to still another aspect of the present invention includes the steps of exposing an object using the above exposure apparatus, and developing the object that has been exposed.

Other objects and further features of the present invention will become readily apparent from the following description of the embodiments with reference to accompanying drawings.
FIG. 1 is a schematic block diagram of an exposure apparatus according to one aspect of the present invention.
FIG. 2 is a schematic sectional view of a prism in the exposure apparatus shown in FIG. 1.
FIG. 3 shows a shape of an effective light source when an effective light source formed by a diffraction optical element is restricted by a stop that restricts an opening angle of the effective light source in a circumferential direction around an optical axis.
FIG. 4 is a flowchart for explaining an exposure method according to one aspect of the present invention.
FIG. 5 shows an effective light source having an asymmetrical quadrupole shape formed by the diffraction optical element shown in FIG. 1.
FIG. 6 shows the effective light source shown in FIG. 5, which is enlarged by a zooming condenser.
FIG. 7 shows an annular effective light source formed by the diffraction optical element shown in FIG. 1.
FIG. 8 shows the effective light source shown in FIG. 7, which is enlarged by a zooming condenser.
FIG. 9 shows the effective light source shown in FIG. 7, which has an annular ratio changed by using the prism.
FIG. 10 is a flowchart for explaining an exposure method as a variation of the exposure method shown in FIG. 4.
FIG. 11 is a flowchart for explaining an exposure method as another variation of the exposure apparatus shown in FIG. 4.
FIG. 12 is a flowchart for explaining a fabrication of devices (semiconductor chips such as ICs, LSIs, and the like, LCDs, CCDs, etc.).
FIG. 13 is a detailed flowchart for Step 4 Wafer Process shown in FIG. 7.

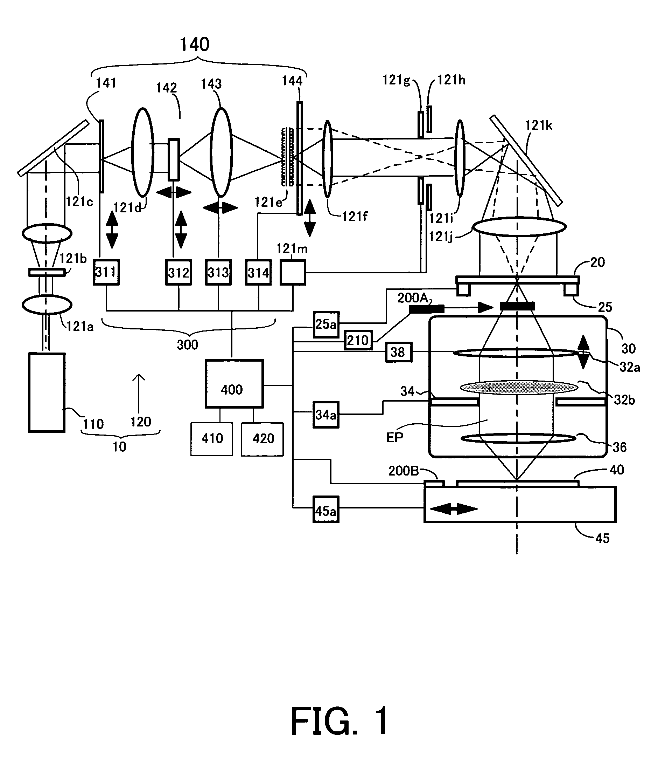

A description will now be given of an exemplary exposure apparatus 1 according to one embodiment of the present invention with reference to accompanying drawings. The same reference numeral in each figure designates the same element, and a duplicate description will. Here, FIG. 1 is a schematic block diagram of the exposure apparatus 1.

The exposure apparatus 1 is a projection exposure apparatus that exposes onto an object 40 a circuit pattern of a reticle 20, e.g., in a step-and-repeat or a step-and-scan manner. Such an exposure apparatus is suitable for a sub-micron or quarter-micron lithography process, and this embodiment exemplarily describes a step-and-scan exposure apparatus (which is also called "a scanner"). The "step-and-scan manner," as used herein, is an exposure method that exposes a mask pattern onto a wafer by continuously scanning the wafer relative to the mask, and by moving, after a shot of exposure, the wafer stepwise to the next exposure area to be shot. The "step-and-repeat manner" is another mode of exposure method that moves a wafer stepwise to an exposure area for the next shot every shot of cell projection onto the wafer.

The exposure apparatus 1 includes, as shown in FIG. 1, an illumination apparatus 10, a reticle stage 25 mounted with the reticle 20, a projection optical system 30, a wafer stage 45 mounted with the object 40, a measuring unit 200, a drive unit 300, and a controller 400.

The illumination apparatus 10 illuminates the reticle 20 which has a circuit pattern to be transferred, and includes a light source unit 110, and an illumination optical system 120.

The light source unit 110 uses a laser, for example. The laser can use an ArF excimer laser with a wavelength of approximately 193 nm, a KrF excimer laser with a wavelength of approximately 248 nm, etc., but the type of the light source is not limited to the excimer laser, and the light source may use an F₂ excimer laser with a wavelength of approximately 153 nm, and an extreme ultraviolet ("EUV") light source with a wavelength less than 20 nm.

The illumination optical system 120 is an optical system for illuminating a surface, such as the reticle 20 having a desired pattern, using the light emitted from the light source section 110, and includes a deflecting optical system 121a, a light stabilizing element 121b, a deflecting mirror 121c, a diffraction optical element 141, a condenser lens 121d, a prism 142, a zooming condenser lens 143, an integrator 121e, a stop 144, a condenser lens 121f, a variable slit 121g, a masking unit 121h, lenses 121i and 121j, and a deflecting mirror 121k. An optical element 140 that determines a shape of the effective light source as an angular distribution of the exposure light incident upon the object 40 includes the diffraction optical system 141, the prism 142, the zooming condenser lens 143, and the stop 144.

The light emitted from the light source section 110 is transformed into a desired light diameter by an operation of the deflecting optical system 121a, and enters the light stabilizing element 121b. The light stabilizing element 121b is, for example, one type of the integrator like a fly-eye lens. The light exited from the light stabilizing element 121b illuminates the diffraction optical element 141 through the diffracting mirror 121c. This configuration can illuminate the diffraction optical element 141 at substantially constant incident angle even when the laser's optical axis fluctuates during the exposure.

The diffraction optical element 141 is arranged near the front focal point of the subsequent condenser lens 121d, and thus a Fourier transformation distribution that has previously designed on the diffraction optical element 141 is formed at the back focal point. The diffraction optical element 141 is a CGH in this embodiment, and plural diffraction optical elements 141 having different shapes of the effective light source are arranged on a turret.

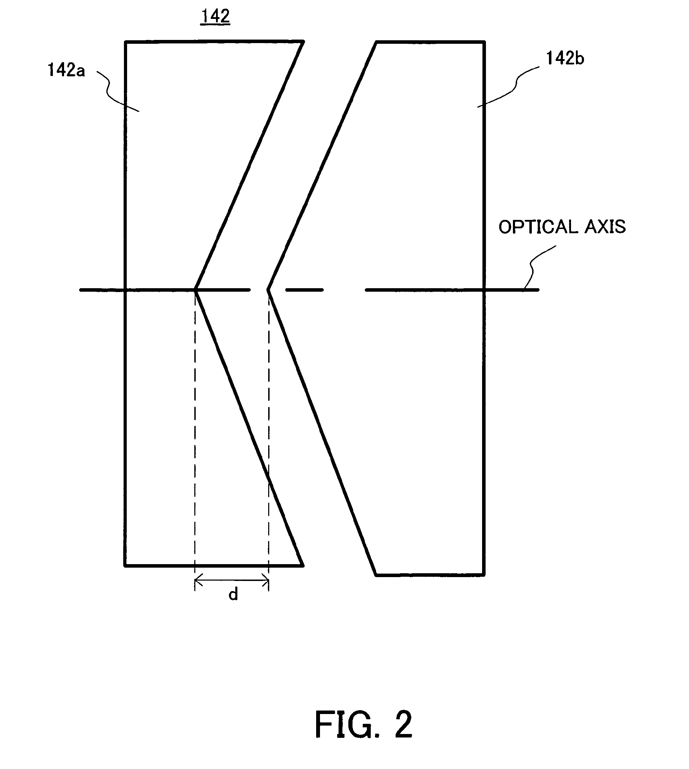

This embodiment switchably arranges plural prisms 142 each serving as a light deflector near the back focus position of the condenser lens 121d. The prism 142 includes a concave prism 142a and a convex prism 142b, which are rotationally symmetrical around the optical axis. As an interval d between the concave prism 142a and the convex prism 142b changes (for zooming), the prism 142 changes a position from the optical axis of a distribution of the light's section formed by the diffraction optical element 141. More specifically, by driving the diffraction optical element 141 in a direction perpendicular to the optical axis, the effective light source can be moved in the driving direction. Changes of the interval between the rotationally symmetrical concave and convex prisms 142a and 142b would symmetrically shift the effective light source distribution around the optical axis. The zooming condenser or zooming optical system 143, which will be described later, can change the size of the effective light source distribution while maintaining the shape of the effective light source. When the diffraction optical element 141 forms an annular distribution of the light's section, the prism 142 can change the annular ratio through the zooming. Here, FIG. 2 is a sectional view showing one exemplary structure of the prism 142 shown in FIG. 1.

The distribution of the light's section on a surface perpendicular to the optical axis of the illumination optical system, which is formed by the diffraction optical system 141 and the prism 142, is enlarged or reduced on an incident surface of the integrator 121e by an operation of the zooming condenser 143 as a subsequent light deflector.

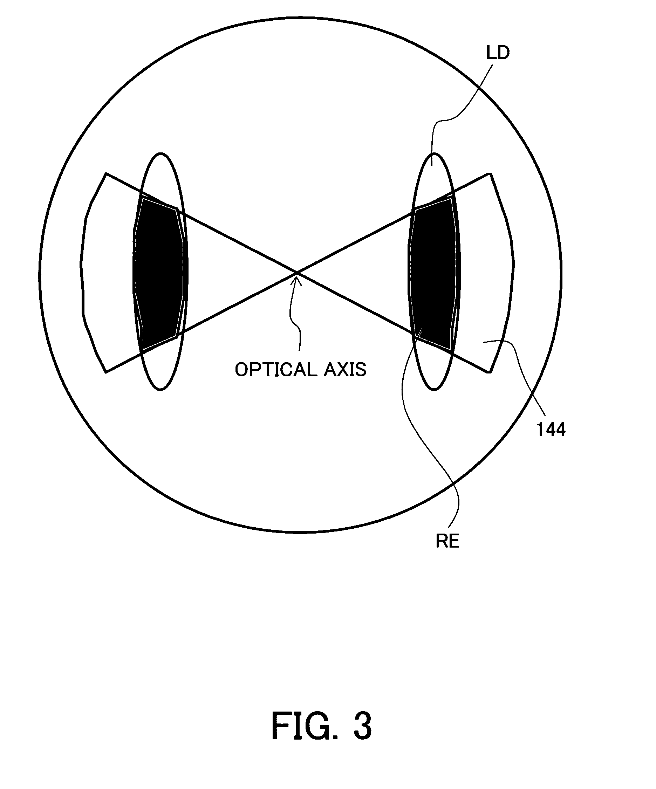

The integrator 141e uses, for example, a fly-eye lens, a dispersion element, a diffraction optical element, etc. Plural stops 144 are switchably arranged near the exit surface of the integrator 141e. This configuration can more strictly define the distribution of the light's section exited from the integrator 141e. FIG. 3 shows the shape of the effective light source when the stop having a sectorial opening restricts the effective light source LD formed by the diffraction optical element 141. Referring to FIG. 3, the effective light source has a dipole shape having a pair of illumination areas RE. The sectorial opening has a variable arc length. Such a shape of the effective light source is effective to a pattern having a period in a direction an arrangement of two poles.

When the diffraction optical element 141 and the prism 142 sufficiently form the light's sectional shape as a desired shape, the stop 144 can be omitted. The exit surface of the stop 144 is arranged at a position optically conjugate with a pupil surface EP in the projection optical system 30. Therefore, the light's sectional shape formed on the exit surface of the stop 144 becomes the effective light source distribution (or the shape of the effective light source) of the illumination optical system 120.

The light exited from the stop 144 condenses at a position near the back focal position of the condenser lens 121f. The variable slit 121g adjusts an uneven integral exposure dose in scanning the reticle 20 and the object 40, and is located at the back focal position. The variable slit 121g serves to make constant the integral exposure dose in a direction orthogonal to the scan direction of the reticle 20 and the object 40 (or the slit's longitudinal direction). The variable slit 121g can change the opening by the drive mechanism 121m.

The masking unit 121h is arranged near the exit surface of the variable slit 121g, and drives in synchronization with scanning of the reticle 20 so as to expose only the effective pattern area on the reticle 20.

The light exited from the variable slit 121g and the masking unit 121h is imaged on the pattern surface of the reticle 20 by a masking imaging system that includes the lenses 121i and 121j, and the deflecting mirror 121k arranged between the lenses 121i and 121j.

The reticle 20 is, *e.g*., of quartz, on which a circuit pattern (or an image) to be transferred is created, and is supported and driven by a reticle stage 25 connected to the drive mechanism 25a. The diffracted light through the reticle 20 is projected through the projection optical system 30 onto the object 40. The reticle 20 and the object 40 are located in an optically conjugate relationship. The exposure apparatus 1 as a scanner scans the reticle 20 and the object 40 using the exposure light, and transfer the pattern of the reticle 20 onto the object 40.

The projection optical system 30 images the light from an object surface, such as the reticle 20, onto an image surface, such as the object 40. The projection optical system 30 may use an optical system solely composed of a plurality of lens elements, an optical system comprised of a plurality of lens elements and at least one concave mirror (a catadioptric optical system), an optical system comprised of a plurality of lens elements and at least one diffractive optical element such as a kinoform, and a full mirror type optical system, and so on. Any necessary correction of the chromatic aberration may use a plurality of lens units made from glass materials having different dispersion values (Abbe values), or arrange a diffractive optical element such that it disperses in a direction opposite to that of the lens unit.

The projection optical system 30 includes upper lens units 32a and 32b, an aperture stop 34 arranged near a pupil surface EP, and a lower lens unit 36, and images the diffracted light from the pattern of the reticle 20 onto the object 40. The upper lens unit 32a has an adjusting mechanism 38 for adjusting the aberration of the projection optical system 30. The adjusting mechanism 38 has means for adjusting zooming and decentering of a lens element in the upper lens unit 32a and means for partially adjusting the air pressure in the barrel. The aperture stop 34 is connected to a drive mechanism 36a, and adapted to vary an opening diameter.

The object 40 is a wafer in this embodiment, but may include a liquid crystal plate and a wide range of other objects to be exposed. Photoresist is applied onto the object 40.

The wafer stage 45 is connected to a drive mechanism 45a, and supports and drives the object 40. The wafer stage 45 may use any structure known in the art, and thus a detailed description of its structure and operations will be omitted. For example, the wafer stage 45 may use a linear motor to move the object 40 in a direction orthogonal to the optical axis. The mask 20 and object 40 are, for example, scanned synchronously, and the positions of the reticle stage 25 and wafer stage 45 are monitored, for example, by a laser interferometer and the like, so that both are driven at a constant speed ratio. The wafer stage 45 is installed on a stage stool supported on the floor and the like, for example, via a damper, and the reticle stage 25 and the projection optical system 30 are installed on a barrel stool (not shown) supported, for example, via a damper to the base-frame placed on the floor.

The measuring unit 200 serves to measure a shape of the effective light source formed by the illumination optical system 120 or a corresponding shape of the exposure light. The measuring unit 200 is implemented, for example, as a two-dimensional sensor, such as a CCD, and a luminance meter. The measuring unit 200 preferably has a measuring area for measuring the shape of the effective light source formed by the illumination optical system 120 and the corresponding shape of the effective light source. Both of the measuring means 200A and 200B, which will be described later, do not have to be provided simultaneously, but at least one of them is provided. The measuring means 200 may be provided near the reticle 20's surface or near the object 40's surface, which is not a position conjugate with the reticle or the object. Here, the measuring unit 200 provided near the reticle 20's surface is referred to as a detector 200A, and the measuring unit 200 provided near the object 40's surface is referred to as a detector 200B.

The detector 200A is arranged near the reticle 20's surface or between the reticle stage 25 and the projection optical system 30. The detector 200A measures a shape of the exposure light that passes the reticle 20 and enters the projection optical system 30. The detector 200A is adapted to be removably inserted into a space between the reticle 20 and the projection optical system 30 by the insertion/ejection mechanism 210. The insertion/ejection mechanism 210 inserts the detector 200A between the reticle 20 and the projection optical system 30 in measuring the shape of the effective light source. In measuring the shape of the effective light source, a special reticle may be loaded and an alignment optical system (not shown) may measure the shape of the effective light source.

The detector 200B is arranged near the object 40's surface or on the wafer stage 45, and serves to measure a shape of the effective light source that has passed the projection optical system 30. While the detector 200B always resides on the wafer stage 45 in FIG. 1, an insertion/ejection mechanism (not shown) similar to that for the detector 200A may insert the detector 200B in measuring the shape of the effective light source.

The drive mechanism 300 serves to drive the optical element 140. The shape of the effective light source formed by the illumination optical system 120 can be adjusted by driving the optical element 140 through the drive unit 300 in the optical-axis direction of the illumination optical system or a direction perpendicular to that direction. The drive unit 300 includes drive mechanisms 311 to 314. The drive mechanism 311 switches the plural diffraction optical elements 141 arranged on the turret to a suitable one having a desired effective light source distribution (or illumination mode). The drive mechanism 312 changes the interval d between the concave and convex prisms 142a and 142b in the prism 142 or switches the prism 142 to another prism under control by the controller 400 so as to vary the optical performance. The drive mechanism 313 drives the zooming lens 143, enlarges or reduces the effective light source distribution under control by the controller 400. The drive mechanism 314 switches the stop 144 or retreats the stop 144 from the optical path under control by the controller 400.

The controller 400 controls not only the entire exposure apparatus 1, but also the scan exposure via the drive mechanisms 121m, 25a, 34a and 45a. The controller 400 automatically controls driving of the optical element 140 by the drive unit 300 based on the shape of the effective light source measured by the measuring unit 200. The controller 400 serves to optimize the shape of the effective light source formed by the illumination optical system 120, and optimizes the projection optical system 300 and other components in this embodiment. In other words, the controller 400 serves to positively drive the upper lens unit 32a via the drive mechanism 38 if the adjustment to the illumination optical system 120 is not enough, and adjust the aberrational characteristics of the projection optical system 30 so that the actual exposure performance can be the required exposure performance. The controller 400 includes a memory 410 and an input part 420.

The memory 410 stores first information indicative of the shape of the effective light source suitable for the reticle 20, and second information indicative of driving of the optical element 140 by the drive unit 300 necessary to adjust the shape of the effective light source. The first information includes optimal illumination mode, such as an annular shape, a dipole shape and a quadrupole shape, an arrangement of the illumination mode, a magnification, a permissible range of the shape of the effective light source required for desired exposure performance for patterns of all the reticle 20 used for the exposure apparatus. The second information includes a relationship between driving of each optical element and changing of the shape of the effective light source, such as a movement of the effective light source in a driving direction when the diffraction optical element is driven in the direction perpendicular to the optical axis, a rotationally symmetrical shift of the effective light source distribution around the optical axis when the concave and convex prisms 142a and 142b are driven, and a change of the size of the effective light source distribution by driving the zooming condenser 143. In other words, the controller 400 can set a shape of the effective light source based on the first information and second information stored in the memory 410.

Input into the input part 420 is information of the initially set shape of the effective light source or the pattern of the reticle 20. The controller 400 refers to the first information stored in the memory 410 and controls the drive unit 300 based on the input information through the input part 420.

While this embodiment provides one control unit (controller 400, memory 410 and input part 420) for one exposure apparatus 1, a control apparatus that serves as the above control unit may be provided for an exposure system having plural exposure apparatuses so that the control apparatus controls these plural exposure apparatuses.

In exposure, a beam emitted from the laser 110 illuminates the reticle 20 by the illumination optical system 120. The light that passes the reticle 20 and reflects a reticle pattern is imaged on the object 40 through the projection optical system 30.

The illumination optical system 120 used for the exposure apparatus 1 can illuminates the reticle,20 with an effective light source optimal to the pattern formed on the reticle 20 by the following exposure method, the exposure apparatus 1 can provide devices (such as semiconductor devices, LCD devices, image pickup devices (such as CCDs), thin film magnetic heads) with good resolution, throughput and economical efficiency.

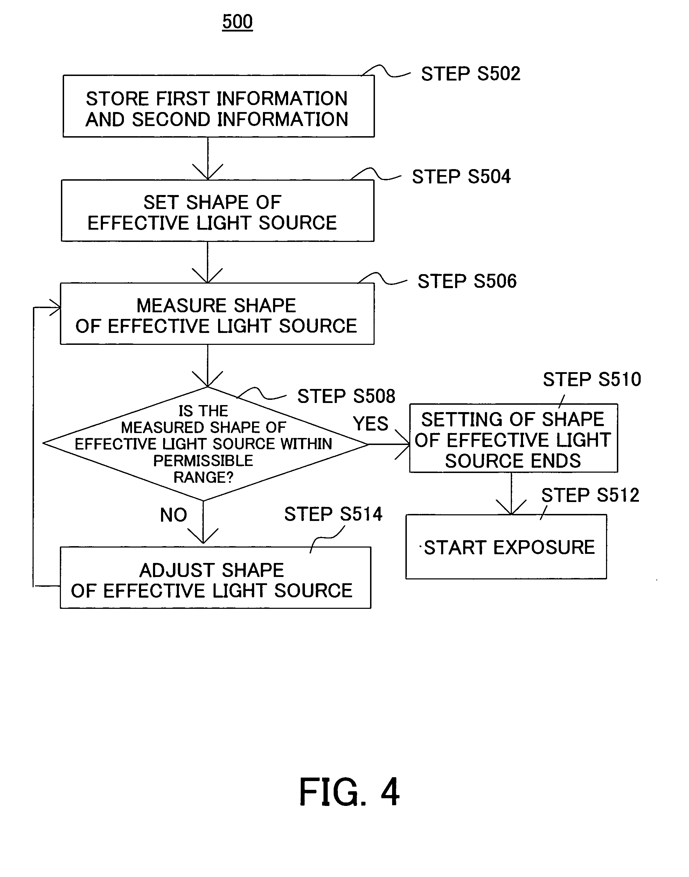

Referring now to FIGs. 4 to 11, a description will be given of an exposure method according to one aspect of the present invention. FIG. 4 is a flowchart for explaining an exposure method 500 according to one aspect of the present invention. The exposure method of this embodiment illuminates the reticle 20 with the light from the illumination apparatus 10, and exposes the pattern of the reticle 20 onto the object 40 via the projection optical system 30.

Referring to FIG. 4, the memory 410 initially stores the first information indicative of the shape of the effective light source suitable for the reticle 20, and second information indicative of driving of the optical element 140 by the drive unit 300 necessary to adjust the shape of the effective light source (step S502). Thereby, the controller 400 can control the shape of the effective light source via the drive unit 300, and determine whether the shape of the effective light source is within a permissible range.

Next, information of the initially set shape of the effective light source or the reticle 20's pattern is input into the input part 420, and the shape of the effective light source is set based on the input information in addition to the first information and the second information stored in the step S502 (step S504). More specifically, the optical element 140, such as the diffraction optical element 141, the prism 142, the zooming condenser 143 and the stop 144, is initially set under control by the controller 400. The condition of the projection optical system 30 may be also set at this time.

Next, the measuring unit 200 measures the shape of the effective light source formed by the illumination optical system 120 (step S506). The measuring unit 200 may directly measure the shape of the effective light source or the controller 400 may calculate the shape of the effective light source based on the measurement result by the measuring unit 200. The controller 400 determines whether the shape of the effective light source measured by the measuring unit 200 is within a permissible range (step S508).

When the shape of the effective light source shape measured by the measuring unit 200 (or compared in the step S508) is within the permissible range, the setting of the effective light source ends (step S510) and the exposure starts (step S512).

When the shape of the effective light source shape measured by the measuring unit 200 (or compared in the step S508) is outside the permissible range, the controller 400 controls the drive unit 300 for driving the optical element 140 that determines the shape of the effective light source and adjusts the shape of the effective light source, based on the first information and the second information (step S514). More specifically, a σ value is enlarged or reduced by the prism 142 and zooming condenser 143 by utilizing the diffraction optical element 141 set by the step S504.

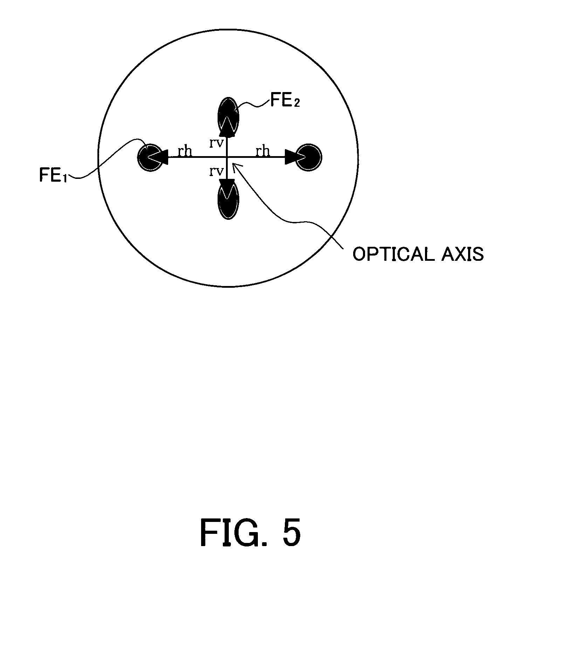

Referring now to FIGs. 5 to 9, a description will be given of the adjustment in the step S514 of the shape of the effective light source. FIG. 5 shows an effective light source having an asymmetrical quadrupole shape formed by the diffraction optical element 141 shown in FIG. 1. The effective light source shown in FIG. 5 has a first illumination area FE₁ apart from the optical axis by a first distance rh in a horizontal direction, and a second illumination area FE₂ apart from the optical axis by a second distance rv different from the first distance rh in a perpendicular direction. The effective light source is effective to a reticle pattern that has different periods in directions horizontal and perpendicular to the optical axis. This effective light source is also effective to corrections to the resolving powers, when the exposure apparatus 1 itself has different resolving powers in the horizontal and perpendicular directions. A conventional prism cannot directly form an effective light source that scatters plural illuminations areas different distances from the optical axis, and a stop is used to cut out the effective light source, inevitably lowering the light use efficiency. On the other hand, the diffraction optical element 141 typified by the CGH can directly form an effective light source having an arbitrary shape, such as the effective light source shown in FIG. 5, without cutting it out using the stop, and improves the high light use efficiency.

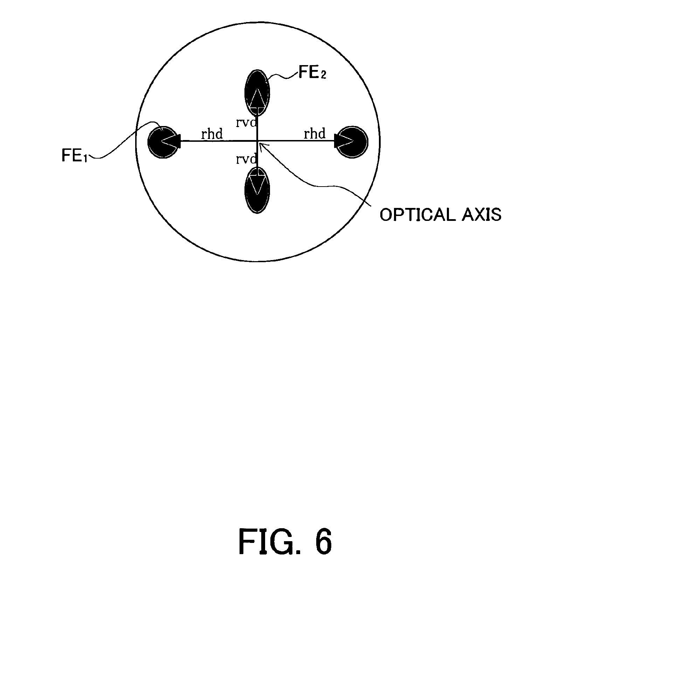

FIG. 6 shows the effective light source shown in FIG. 5, which is enlarged by the zooming condenser 143. Referring to FIG. 6, the first and second illumination areas FE₁ and FE₂ are apart from the optical axis by a first distance rhd in the horizontal direction and a second distance rvd in the perpendicular direction, and are enlarged at a certain ratio. Although not shown, the diameters of first and second illumination areas FE₁ and FE₂ are enlarged at the same ratio as that for the first and second distances.

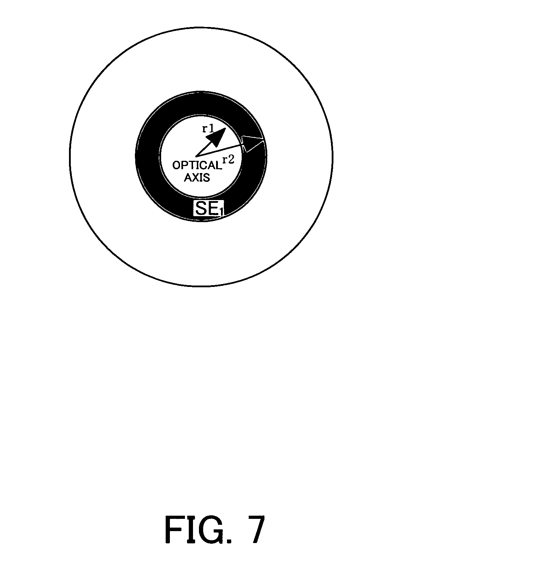

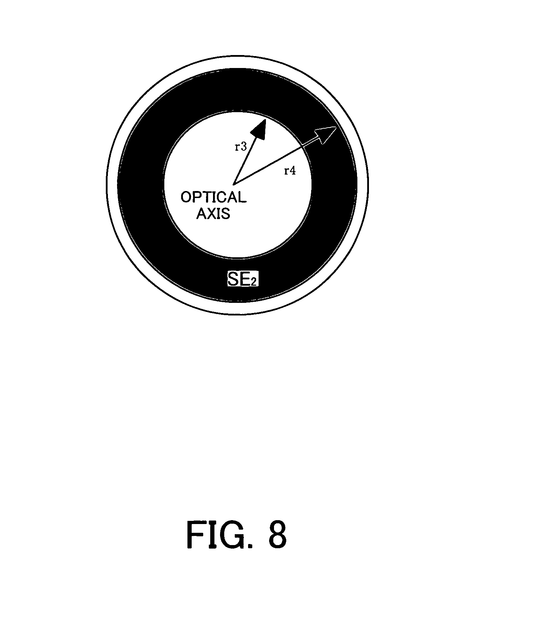

FIG. 7 shows an annular effective light source formed by the diffraction optical element 141 shown in FIG. 1. The effective light source shown in FIG. 7 has an annular illumination area SE₁ with an inner diameter r1 and an outer diameter r2 from the optical axis. FIG. 8 shows the effective light source shown in FIG. 7, which is enlarged by the zooming condenser 143. Referring to FIG. 8, the illumination area SE₁ shown in FIG. 7 is enlarged to an illumination area SE₂ with an inner diameter r3 and an outer diameter r4. Since this case enlarges the entire effective light source, the annular ratio or (an inner diameter) / (an outer diameter) does not change.

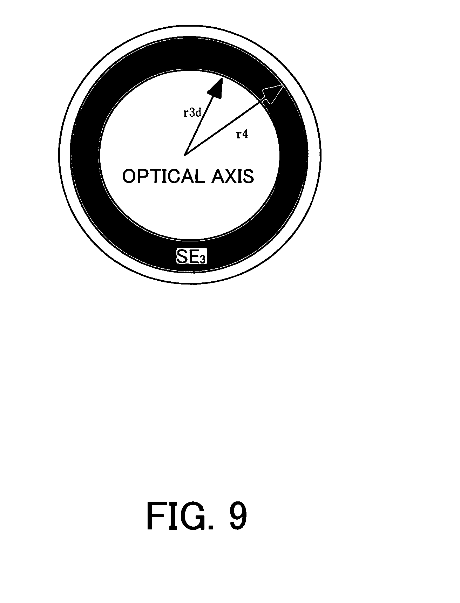

FIG. 9 shows the effective light source shown in FIG. 7, which has an annular ratio changed by using the prism 142. FIG. 9 shows the effective light source having an illumination area SE₃ having a large annular ratio by using the same outer diameter r4 as that in FIG. 8, and the enlarged inner diameter r3d.

As shown in FIGs. 6, 8 and 9, a refractive element, such as the prism 142 and the zooming condenser 143, is suitable for rotationally symmetrical adjustments or changes to the effective light source around the optical axis. This embodiment uses the diffraction optical element 141 to form an effective light source having illumination areas that scatter and are located apart from the optical axis by different distances, and adjusts the effective light source in a rotationally symmetry through the refractive element. Thereby, an efficient shape of the effective light source (or the effective light source distribution) is formed by taking advantage of characteristics of the diffraction optical element and the refractive element.

When the adjustment to the effective light source in the step S514 ends, the measuring unit 200 measures the shape of the effective light source again (step S506), determines whether the measured effective light source is within a permissible range (step S508), and repetitively adjusts the shape of the effective light source until the shape of the effective light source falls within the permissible range (step S514).

If the effective light source does not fall within the permissible range even after the shape of the effective light source is adjusted by driving the optical element 140 in the illumination optical system 120, the diffraction optical element 141 is switched. A design value of the effective light source formed by plural diffraction optical elements 141 has been stored in the controller 400. If it is finally determined that the permissible effective light source cannot be obtained through the steps S502, S504, S506, S508 and S514, an alarm can be obtained.

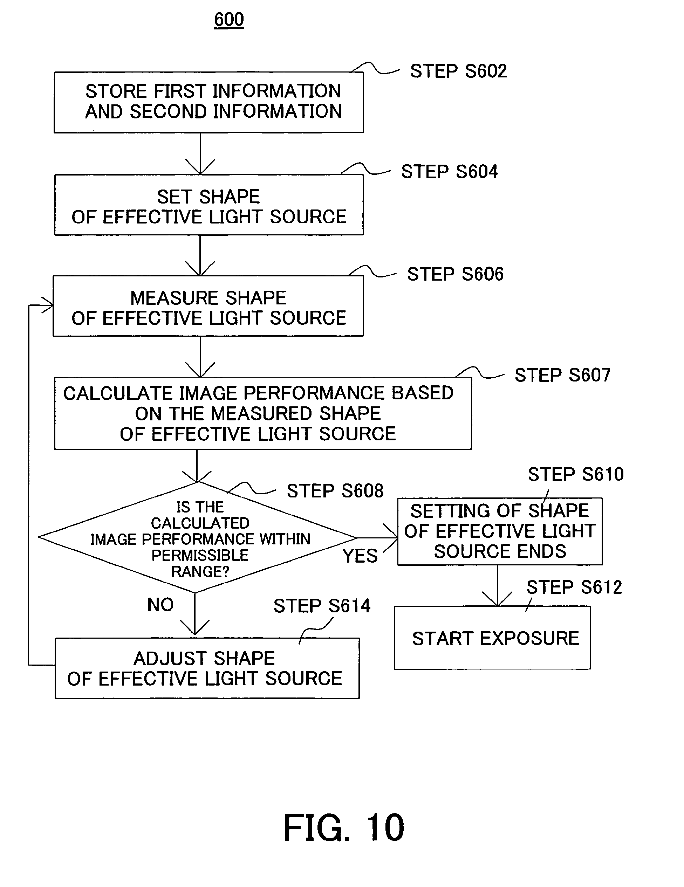

A description will be given of an exposure method 600 as a variation of the exposure method 500 shown in FIG. 4. FIG. 10 is a flowchart for explaining an exposure method 600 as a variation of the exposure method 500 shown in FIG. 4. The exposure method 600 of the instant embodiment is different from the exposure method 500 in the determinant for determining whether the shape of the effective light source is within a permissible range. The exposure method 500 determines the shape of the effective light source itself, whereas the exposure method 600 determines the image performance.

Referring to FIG. 10, the memory 410 initially stores the first information indicative of the shape of the effective light source suitable for the reticle 20, and second information indicative of driving of the optical element 140 by the drive unit 300 necessary to adjust the shape of the effective light source (step S602). The first information includes information relating to the image performance when the reticle 20's pattern is exposed with an optimal effective light source. The information relating to the image performance includes, for example, a CD variance to a period of a repetitive wiring pattern (an optical proximity effect), and the exposure process allowability (or a CD stability relative to the fluctuations of the focus and the exposure dose). The sensitivities by which these various characteristics are affected by the shape of the effective light source are previously stored and used for step S608, which will be described later.

Next, information of the initially set shape of the effective light source or the reticle 20's pattern is input into the input part 420, and the shape of the effective light source is set based on the input information in addition to the first information and the second information stored in the step S602 (step S604). The condition of the projection optical system 30 may be also set at this time.

Next, the measuring unit 200 measures the shape of the effective light source formed by the illumination optical system 120 (step S606). The measuring unit 200 may directly measure the shape of the effective light source or the controller 400 may calculate the shape of the effective light source based on the measurement result by the measuring unit 200. The controller 400 calculates the image performance from the shape of the effective light source measured by the measuring unit 200 (step S607).

The controller 400 determines whether the image performance calculated in the step 607 is within a permissible range (step S608). When the image performance calculated in step S607 is within the permissible range, the setting of the effective light source ends (step S610) and the exposure starts (step S612).

When the image performance calculated in step S607 is outside the permissible range, the controller 400 controls the drive unit 300 for driving the optical element 140 that determines the shape of the effective light source and adjusts the shape of the effective light source, based on the first information and the second information (step S614). When the adjustment of the effective light source in the step S614 ends, the measuring unit 200 measures the shape of the effective light source again (step S606), and calculates the image performance from the measured shape of the effective light source (step S607). Then, the controller 400 determines whether the measured effective light source is within a permissible range (step S608), and repetitively adjusts the shape of the effective light source until the shape of the effective light source falls within the permissible range (step S614).

While the step S608 in the above embodiment compares the image performance calculated from the shape of the effective light source measured in step S606 with the first information stored in the step S602, a combination between the aberrational characteristic of the projection optical system 30 and the storage information, which is measured differently from the step S608, may be used for comparison. When the calculated image performance is determined outside the permissible range, the drive unit 300 for driving the optical element in the illumination optical system 120 and the upper lens unit 32a in the projection optical system 30 are controlled are controlled and the shape of the effective light source is adjusted.

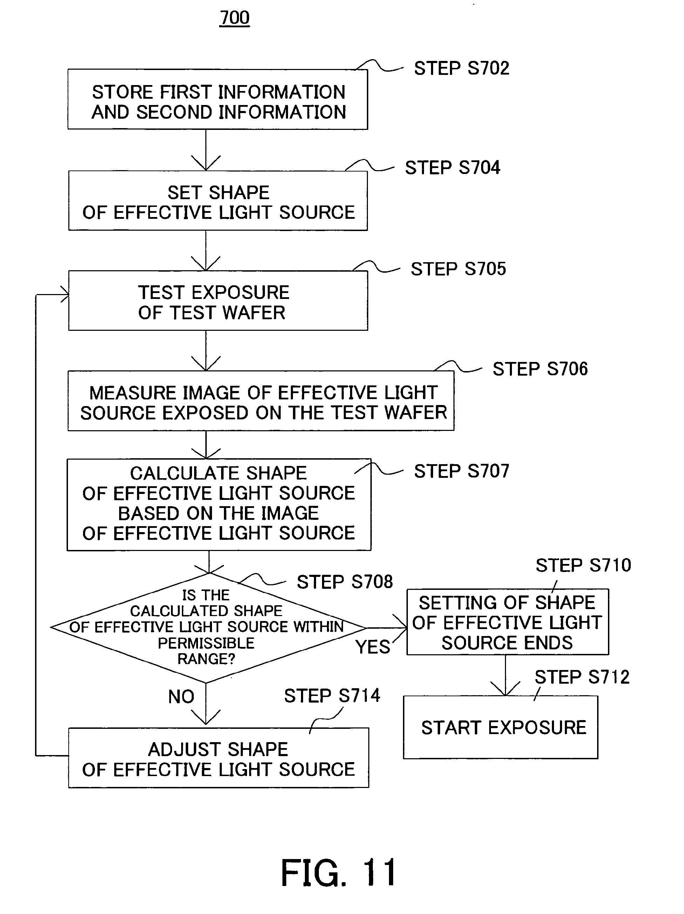

A description will be given of an exposure method 700 as a variation of the exposure method 500 shown in FIG. 4. FIG. 11 is a flowchart for explaining an exposure method 700 as a variation of the exposure method 500 shown in FIG. 4. The exposure method 700 of the instant embodiment is different from the exposure method 500 in a method for measuring the shape of the effective light source.

Referring to FIG. 11, the memory 410 initially stores the first information indicative of the shape of the effective light source suitable for the reticle 20, and second information indicative of driving of the optical element 140 by the drive unit 300 necessary to adjust the shape of the effective light source (step S702).

Next, information of the initially set shape of the effective light source or the reticle 20's pattern is input into the input part 420, and the shape of the effective light source is set based on the input information in addition to the first information and the second information stored in the step S702 (step S704). The condition of the projection optical system 30 may be also set in this case. Next, a resist applied test wafer is tentatively exposed (step S705), and an image of the effective light source exposed on the test wafer is measured (step S706). The image of the effective light source can be formed by providing a pinhole in the reticle, and arranging the wafer at a position defocused from the conjugate surface of the pinhole, and exposing the wafer.

Next, the controller 400 calculates the shape of the effective light source from the image of the effective light source measured in step S706 (step S707), and determines whether the calculated shape of the effective light source is within a permissible range (step S708). When the calculated image performance is within the permissible range, the setting of the effective light source ends (step S710) and the exposure starts (step S712).

When the calculated shape of the effective light source is outside the permissible range, the controller 400 controls the drive unit 300 for driving the optical element 140 that determines the shape of the effective light source and adjusts the shape of the effective light source (step S714). When the adjustment of the effective light source in the step S714 ends, the test wafer is exposed again (step S705), and the image of the effective light source is measured again (step S706). The controller 400 calculates the shape of the effective light source from the re-measured image of the effective light source (step S707), and determines whether it is within the permissible range (step S708), and repetitively adjusts the shape of the effective light source until the shape of the effective light source falls within the permissible range (step S714).

Similar to the above exposure method 600, the exposure method 700 may calculate the image performance from the image of the effective light source, determine and adjust the shape of the effective light source based on the image performance.

As discussed, according to the exposure apparatus and method of the instant embodiment, even when the design and manufacture of the diffraction optical element, such as a CGH, include various errors, the shape of the effective light source suitable for the reticle pattern can be precisely adjusted and the desired exposure performance (such as high resolution) can be obtained. As a result, the yield of the semiconductor device improves.

Since the shape of the effective light source is automatically adjusted without remanufacturing the diffraction optical element, the operator needs no arduous tasks, reduces the adjustment time period, and improves the throughput. Since one diffraction optical element may possibly be used for plural illumination optical modes, the degree of freedom of the illumination condition enlarges.

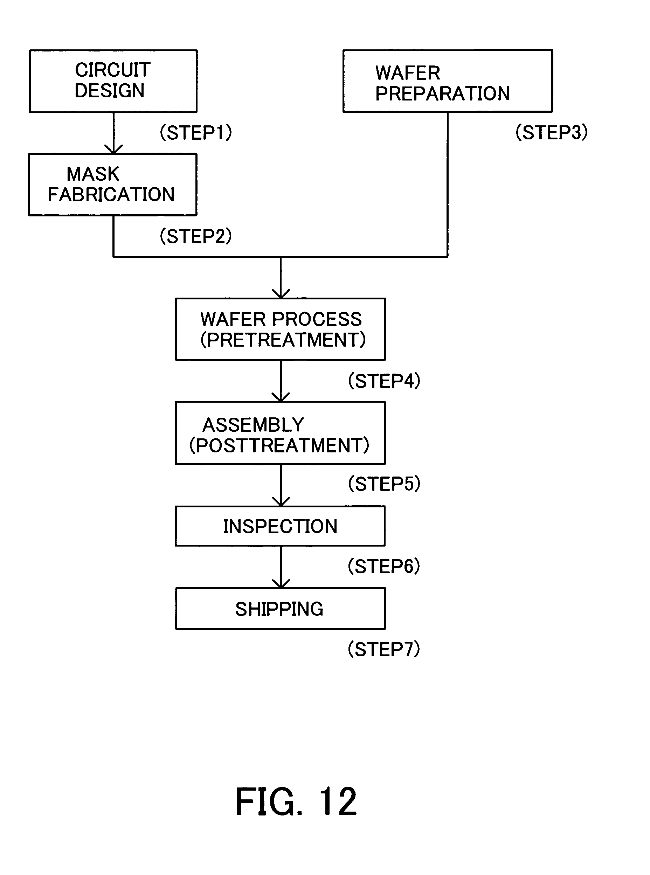

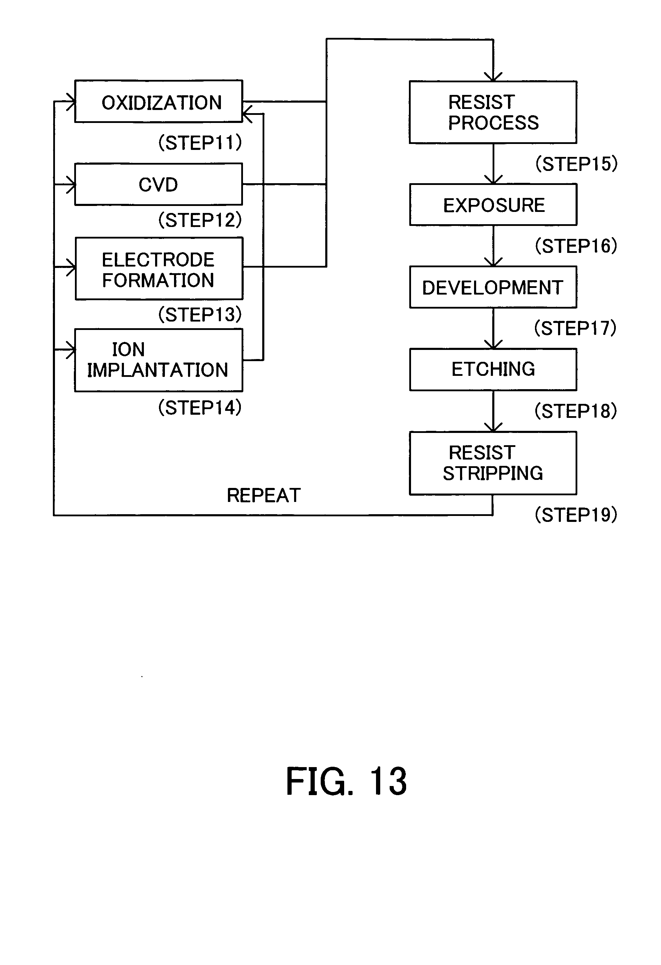

Referring to FIGs. 12 and 13, a description will now be given of an embodiment of a device manufacturing method using the above exposure apparatus 1. FIG. 12 is a flowchart for explaining manufactures of devices (*i*.*e*., semiconductor chips such as IC and LSI, LCDs, CCDs, etc.). Here, a description will be given of the manufacture of a semiconductor chip as an example. Step 1 (circuit design) designs a semiconductor device circuit. Step 2 (mask fabrication) forms a mask having a designed circuit pattern. Step 3 (wafer preparation) manufactures a wafer using materials such as silicon. Step 4 (wafer process), which is also referred to as a pretreatment, forms actual circuitry on the wafer through photolithography of the present invention using the mask and wafer. Step 5 (assembly), which is also referred to as a posttreatment, forms into a semiconductor chip the wafer formed in Step 4 and includes an assembly step (*e.g.*, dicing, bonding), a packaging step (chip sealing), and the like. Step 6 (inspection) performs various tests for the semiconductor device made in Step 5, such as a validity test and a durability test. Through these steps, a semiconductor device is finished and shipped (Step 7).

FIG. 8 is a detailed flowchart of the wafer process in Step 4. Step 11 (oxidation) oxidizes the wafer's surface. Step 12 (CVD) forms an insulating film on the wafer's surface. Step 13 (electrode formation) forms electrodes on the wafer by vapor disposition and the like. Step 14 (ion implantation) implants ions into the wafer. Step 15 (resist process) applies a photosensitive material onto the wafer. Step 16 (exposure) uses the exposure apparatus 1 to expose a circuit pattern on the mask onto the wafer. Step 17 (development) develops the exposed wafer. Step 18 (etching) etches parts other than a developed resist image. Step 19 (resist stripping) removes disused resist after etching. These steps are repeated, and multi-layer circuit patterns are formed on the wafer. The device manufacturing method of this embodiment may manufacture higher quality devices than the conventional one. Thus, the device manufacturing method using the exposure apparatus 1, and the devices as resultant products also constitute one aspect of the present invention.

Further, the present invention is not limited to these preferred embodiments, and various modifications and changes may be made in the present invention without departing from the spirit and scope thereof.

An exposure apparatus includes a projection optical system for projecting a pattern of a reticle onto an object to be exposed, by utilizing exposure light, an optical element for determining a shape of an effective light source, a drive unit for driving the optical element, a measuring unit for measuring the shape of the effective light source or a corresponding shape of the exposure light, and a controller for controlling driving of the optical element by the drive unit and for adjusting the shape of the effective light source based on a measurement result by the measuring unit.

## Claims

1. An exposure apparatus that projects a pattern of a reticle onto an object to be exposed, by utilizing exposure light, via a projection optical system, said exposure apparatus **characterized in that** said exposure apparatus comprises:
an optical element for determining a shape of an effective light source;
a drive unit for driving said optical element;
a measuring unit for measuring the shape of the effective light source or a corresponding shape of the exposure light; and
a controller for controlling driving of said optical element by said drive unit and for adjusting the shape of the effective light source based on a measurement result by said measuring unit.

2. An exposure apparatus according to claim 1, wherein the effective light source has a first illumination area apart from an optical axis by a first distance, and a second illumination area apart from the optical axis by a second distance different from the first distance.

3. An exposure apparatus according to claims 1, wherein said optical element includes a diffraction optical element, and
wherein said controller controls driving of the diffraction optical element and adjusts the shape of the effective light source.

4. An exposure apparatus according to claim 1, wherein said optical element includes a prism, and
wherein said controller controls driving of the prism and adjusts the shape of the effective light source.

5. An exposure apparatus according to claim 1, wherein said optical element includes a zooming optical system, and
wherein said controller controls driving of the zooming optical system and adjusts the shape of the effective light source.

6. An exposure apparatus according to claim 1, wherein said optical element has a stop having a sectoral opening whose shape is variable.

7. An exposure apparatus according to claim 1, further comprising a reticle stage for holding the reticle,
wherein said measuring unit includes:
a detector, arranged between said reticle stage and said projection optical system, for measuring the shape of the exposure light; and
a mechanism for inserting the detector into and for removing the detector from a space between the reticle and said projection optical system.

8. An exposure apparatus according to claim 1, further comprising a stage for holding the object,
wherein said measuring unit includes a detector, provided on said stage, for measuring the shape of the exposure light.

9. An exposure apparatus according to claim 1, further comprising a memory for storing first information indicative of the shape of the effective light source shape suitable for the pattern, and second information indicative of driving by said driving unit necessary to adjust the shape of the effective light source.

10. An exposure apparatus comprising:
a projection optical system for projecting a pattern of a reticle onto an object to be exposed, by utilizing exposure light;
a reticle stage for holding the reticle; and
a detector, arranged between said reticle stage and said projection optical system, for detecting a shape of the exposure light.

11. An exposure apparatus comprising:
a projection optical system for projecting a pattern of a reticle onto an object to be exposed, by utilizing exposure light; and
an optical element for determining a shape of an effective light source,
wherein said optical element includes:
a diffraction optical element for transforming a shape of the exposure light into a predetermined shape; and
a light deflector for transforming the shape of the exposure light from the diffraction optical element into a rotationally symmetrical shape, and
wherein the predetermined shape has a first illumination area apart from an optical axis by a first distance, and a second illumination area apart from the optical axis by a second distance different from the first distance.

12. An exposure apparatus according to claim 11, wherein the light deflector includes a prism that shifts the shape of the exposure light around an optical axis.

13. An exposure apparatus according to claim 11, wherein the light deflector includes a zooming optical system for enlarging or reducing the shape of the exposure light.

14. An exposure method for transferring a pattern of a reticle onto an object to be exposed, via a projection optical system using exposure light, said exposure method comprising the steps of:
obtaining information of a shape of an effective light source;
calculating image performance of the pattern to be transferred onto the object based on the information; and
driving, based on the image performance that has been calculated, an optical element for determining the shape of the effective light source.

15. An exposure method according to claim 14, wherein said calculating step calculates the image performance of the pattern to be transferred onto the object based on the information of the shape of the effective light source and performance of the projection optical system.

16. An exposure method according to claim 14, wherein said calculating step calculates the image performance of the pattern to be transferred onto the object based on the information of the shape of the effective light source and information of an optical proximity effect.

17. An exposure method according to claim 14, wherein said obtaining step obtains the information of the shape of the effective light source by measuring an image of the effective light source obtained from a test exposure.

18. A device manufacturing method comprising the steps of:
exposing an object using an exposure apparatus according to claim 10; and
developing the object that has been exposed.

19. An exposure apparatus comprising:
a projection optical system for projecting a pattern of a reticle onto an object to be exposed, by utilizing exposure light;
an optical element for determining a shape of an effective light source;
a drive unit for driving said optical element;
a measuring unit for measuring the shape of the effective light source or a corresponding shape of the exposure light; and
a controller that calculates image performance of the pattern to be transferred to the object based on a measurement result by said measuring unit, and controls driving of an optical element for determining the shape of the effective light source based on the calculated image performance.
